# EUROPEAN PATENT APPLICATION

(11) **EP 4 637 291 A1**
(43) Date of publication of application: **22.10.2025**
(21) Application number: 25170354.2
(22) Date of filing: 14.04.2025
(51) Int. Cl.: H10B 12/00, G11C 11/408, G11C 11/4091, G11C 11/4097

(54) **SEMICONDUCTOR DEVICES INCLUDING PERIPHERAL CIRCUIT REGIONS**

(30) Priority: 15.04.2024 KR 20240050104
(71) Applicant: Samsung Electronics Co., Ltd., Suwon-si, Gyeonggi-do 16677 (KR)
(72) Inventor: SUNG, Sanghyun, Suwon-si, Gyeonggi-do 16677 (KR); HAN, Jinwoo, Suwon-si, Gyeonggi-do 16677 (KR)
(74) Representative: Kuhnen & Wacker Patent- und Rechtsanwaltsbüro PartG mbB

(57) **Abstract**

A semiconductor device includes a memory cell region (CA) and a peripheral circuit region (PERI1) adjacent the memory cell region (CA) in a first horizontal direction (X). The memory cell region (CA) includes cell channel structures extending in the first horizontal direction (X) and spaced apart from each other in a vertical direction (Z); a cell bitline (BL) extending in the vertical direction (Z); and cell gate electrodes overlapping the cell channel structures in the vertical direction (Z) and extending in a second horizontal direction (Y). The peripheral circuit region (PERI1) includes a peripheral channel structure extending in the first horizontal direction (X); a peripheral bitline extending in the vertical direction (Z); and a first peripheral gate electrode and a second peripheral gate electrode overlapping the peripheral channel structure in the vertical direction (Z) and extending in the second horizontal direction (Y). At least one of the cell channel structures is at a same level as the peripheral channel structure in the vertical direction (Z).

## Description

### FIELD OF THE INVENTION

Example embodiments of the present disclosure relate to a semiconductor device including a peripheral circuit region.

### BACKGROUND OF THE INVENTION

As demand for high performance, high speed, and/or multifunctionality of a semiconductor device has increased, integration density of a semiconductor device has increased. In manufacturing a semiconductor device having fine patterns in response to demand for high integration density of a semiconductor device, it may be necessary to implement patterns having a fine width or a fine spacing distance. Also, it may be necessary to reduce a size of a semiconductor device.

### SUMMARY

An example embodiment of the present disclosure is to provide a semiconductor device including a first peripheral circuit region disposed at a same level or layer of a semiconductor structure as a memory cell region.

According to an example embodiment of the present disclosure, a semiconductor device includes a memory cell region; and a peripheral circuit region adjacent the memory cell region in a first horizontal direction, wherein the memory cell region includes cell channel structures extending in the first horizontal direction and stacked and spaced apart from each other in a vertical direction that is perpendicular to the first horizontal direction; a cell bitline extending in the vertical direction and in contact with the cell channel structures; and cell gate electrodes overlapping the cell channel structures in the vertical direction and extending in a second horizontal direction intersecting the first horizontal direction, wherein the peripheral circuit region includes a peripheral channel structure extending in the first horizontal direction; a peripheral bitline extending in the vertical direction and in contact with the peripheral channel structure; and a first peripheral gate electrode and a second peripheral gate electrode overlapping the peripheral channel structure in the vertical direction and extending in the second horizontal direction, wherein the first peripheral gate electrode is closer to the peripheral bitline than the second peripheral gate electrode, and wherein at least one of the cell channel structures is at a same level as the peripheral channel structure in the vertical direction.

According to an example embodiment of the present disclosure, a semiconductor device includes a first structure including a memory cell region and a first peripheral circuit region; and a second structure overlapping the first structure in a vertical direction and including a core circuit region and a second peripheral circuit region, wherein the first peripheral circuit region includes a peripheral channel structure extending in a first horizontal direction that is perpendicular to the vertical direction; a peripheral bitline extending in the vertical direction and in contact with the peripheral channel structure; and a first peripheral gate electrode and a second peripheral gate electrode overlapping the peripheral channel structure in the vertical direction and extending in a second horizontal direction intersecting the first horizontal direction, wherein the first peripheral gate electrode is closer to the peripheral bitline than the second peripheral gate electrode, and wherein the first peripheral circuit region overlaps the second peripheral circuit region in the vertical direction.

According to an example embodiment of the present disclosure, a semiconductor device includes a memory cell region; and a peripheral circuit region adjacent the memory cell region in a first horizontal direction, wherein the memory cell region includes cell channel structures extending in the first horizontal direction and stacked and spaced apart from each other in a vertical direction that is perpendicular to the first horizontal direction; a cell bitline extending in the vertical direction and in contact with the cell channel structures; a capacitor structure extending in the vertical direction and in contact with the cell channel structures; cell gate electrodes overlapping the cell channel structures in the vertical direction and extending in a second horizontal direction intersecting the first horizontal direction; cell gate dielectric layers between the cell channel structures and the cell gate electrodes; and a cell contact structure on the cell bitline, wherein the peripheral circuit region includes a peripheral channel structure extending in the first horizontal direction; a peripheral bitline extending in the vertical direction and in contact with the peripheral channel structure; a first peripheral gate electrode and a second peripheral gate electrode overlapping the peripheral channel structure in the vertical direction and extending in the second horizontal direction, wherein the first peripheral gate electrode is closer to the peripheral bitline than the second peripheral gate electrode; a first peripheral gate dielectric layer between the peripheral channel structure and the first peripheral gate electrode; and a peripheral contact structure on the peripheral bitline, wherein at least one of the cell channel structures the peripheral channel structure have respective surfaces that are substantially coplanar, and wherein at least a portion of the peripheral contact structure the cell contact structure have respective surfaces that are substantially coplanar.

### BRIEF DESCRIPTION OF DRAWINGS

The above and other aspects, features, and advantages of the present disclosure will be more clearly understood from the following detailed description, taken in combination with the accompanying drawings, in which:
FIG. 1 is a perspective view illustrating a semiconductor device according to example embodiments of the present disclosure;
FIG. 2A is a circuit diagram illustrating a memory cell in a memory cell region according to an example embodiment of the present disclosure;
FIGS. 2B and 2C are circuit diagrams illustrating circuit devices in core circuit regions according to an example embodiment of the present disclosure;
FIG. 3 is a vertical cross-sectional view illustrating the semiconductor device illustrated in FIG. 1, taken along line I-I';
FIG. 4 is a plan view illustrating a memory cell region according to an example embodiment of the present disclosure;
FIG. 5A is a vertical cross-sectional view illustrating the memory cell region illustrated in FIG. 4, taken along line II-II';
FIG. 5B is an enlarged view illustrating a capacitor structure illustrated in FIG. 5A;
FIG. 6 is a perspective view illustrating a memory cell according to an example embodiment of the present disclosure;
FIG. 7 is a circuit diagram illustrating a peripheral circuit device in a first peripheral circuit region according to an example embodiment of the present disclosure;
FIG. 8 is a plan view illustrating a first peripheral circuit region according to an example embodiment of the present disclosure;
FIG. 9 is a vertical cross-sectional view illustrating the first peripheral circuit region illustrated in FIG. 8, taken along line III-III';
FIG. 10A is a perspective view illustrating an antifuse memory cell in a first peripheral circuit region according to an example embodiment of the present disclosure;
FIG. 10B is a perspective view illustrating an antifuse memory cell in a first peripheral circuit region according to an example embodiment of the present disclosure;
FIG. 11 is a plan view illustrating a first peripheral circuit region according to an example embodiment of the present disclosure;
FIG. 12 is a vertical cross-sectional view illustrating the first peripheral circuit region illustrated in FIG. 11, taken along line IV-IV';
FIG. 13 is a perspective view illustrating an antifuse memory cell in a first peripheral circuit region according to an example embodiment of the present disclosure; and
FIGS. 14A, 14B, 15A, 15B, 16A, 16B, 17A, 17B, 18A, and 18B are plan views and vertical cross-sectional views illustrating processes of a method of manufacturing a semiconductor device in order according to an example embodiment of the present disclosure.

### DETAILED DESCRIPTION OF EMBODIMENTS

Hereinafter, embodiments of the present disclosure will be described as follows with reference to the accompanying drawings. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present.

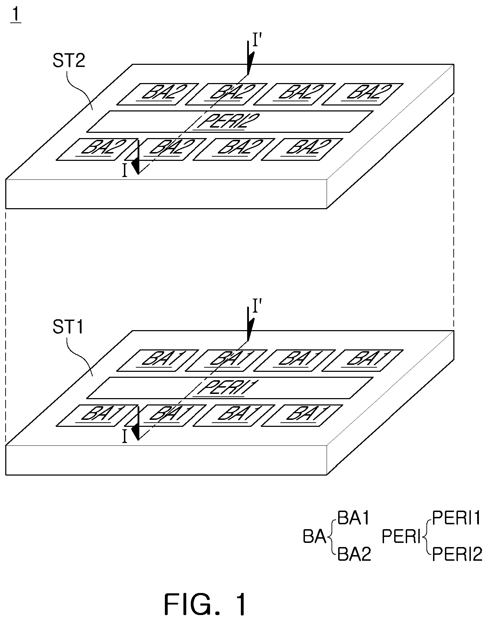

FIG. 1 is a perspective view illustrating a semiconductor device according to example embodiments.

Referring to FIG. 1, a semiconductor device 1 according to an example embodiment may include a first structure ST1 and a second structure ST2 vertically overlapping the first structure ST1. Components or layers described with reference to "overlap" in a particular direction may be at least partially obstructed by one another when viewed along a line extending in the particular direction or in a plane perpendicular to the particular direction. The second structure ST2 may be disposed on the first structure ST1 in a vertical direction (e.g., the Z-direction).

In an example embodiment, the first structure ST1 may be configured as a first chip structure including memory cells MC, and the second structure ST2 may be configured as a second chip structure including a peripheral circuit which may operate the memory cells MC. The first structure ST1 and the second structure ST2 may be bonded through a bonding process such as a wafer bonding process. Accordingly, the first structure ST1 may be in contact with and bonded to the second structure ST2.

The semiconductor device 1 may include a plurality of banks BA and a peripheral circuit region PERI. The peripheral circuit region PERI may include a first peripheral circuit region PERI1 in the first structure ST1 and a second peripheral circuit region PERI2 in the second structure ST2. The peripheral circuit region PERI may be configured as a peripheral circuit region in which peripheral circuits for input/output of data or commands, or input of power/ground are disposed.

Each of the plurality of banks BA may include a first bank region BA1 in the first structure ST1 and a second bank region BA2 in the second structure ST2.

The first bank region BA1 in the first structure ST1 may include memory cell regions CA. The memory cell regions CA may be arranged in the X-direction and Y-direction. The X-direction and the Y-direction may be perpendicular to each other. The X-direction and the Y-direction may be referred to as horizontal or lateral directions, and the Z-direction may be referred to as a vertical direction.

The second bank region BA2 in the second structure ST2 may include core circuit regions CR. The core circuit regions CR may be arranged in the X-direction and the Y-direction. The core circuit regions CR may overlap the memory cell regions CA in the vertical direction Z. Components or layers described with reference to "overlap" in a particular direction may be at least partially obstructed by one another when viewed along a line extending in the particular direction or in a plane perpendicular to the particular direction. The core circuit regions CR may include a sense amplifier SA a and sub-wordline driver SWD.

The first peripheral circuit region PERI1 and the second peripheral circuit region PERI2 may include a control circuit which may control the sense amplifier SA and the sub-wordline driver SWD.

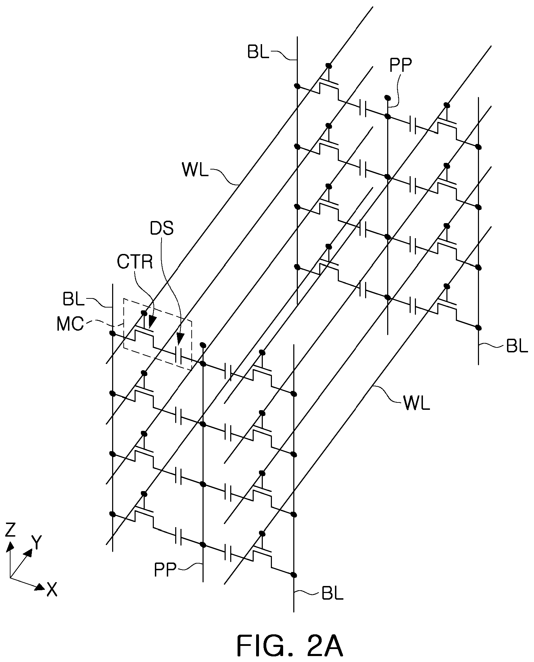

FIG. 2A is a circuit diagram illustrating a memory cell in a memory cell region according to an example embodiment.

Referring to FIG. 2A, the memory cell region CA may include memory cells MC arranged in the X-direction and the Y-direction, wordlines WL connected to the memory cells MC and extending in the Y-direction, and bitlines BL connected to the memory cells MC and extending in the vertical direction.

Each of the memory cells MC may include a cell transistor CTR and a data storage structure DS which may store data. In a memory such as a DRAM, the data storage structure DS may be configured as a cell capacitor which may store data. Data storage structures DS adjacent to each other may share a plate electrode PP. For example, the plate electrode PP may extend in a vertical direction and may be electrically connected to the data storage structures DS.

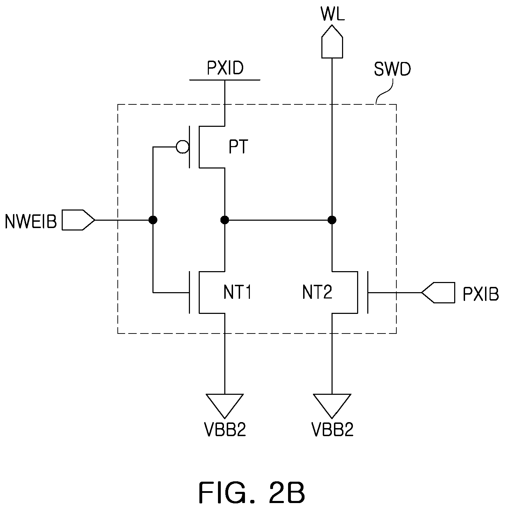

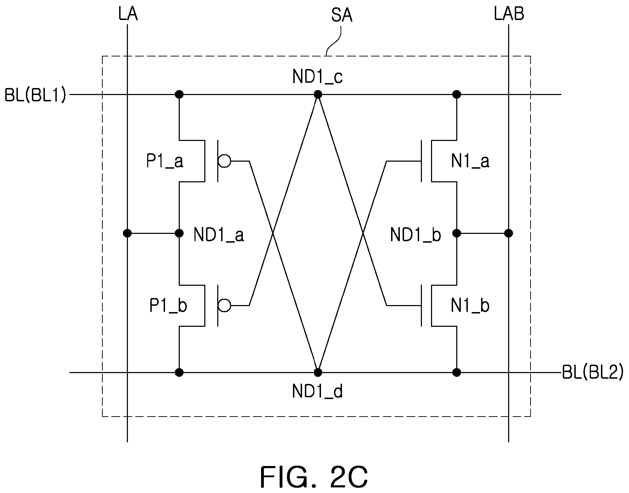

FIGS. 2B and 2C are circuit diagrams illustrating circuit devices in core circuit regions according to an example embodiment. FIG. 2B is a circuit diagram illustrating an example of a sub-wordline driver in a core circuit region according to an example embodiment, and FIG. 2C is a circuit diagram illustrating an example of a sense amplifier in a core circuit region according to an example embodiment.

Referring to FIG. 2B, the sub-wordline drivers SWD may be electrically connected to the wordlines WL. Each of the sub-wordline drivers SWD may include a PMOS transistor PT, a first NMOS transistor NT1, and a second NMOS transistor NT2. The driving signal PXID may be connected to a source terminal of the PMOS transistor PT, the wordline WL may be electrically connected to a drain terminal of the PMOS transistor PT, and the wordline enable signal NWEIB may be connected to a gate terminal of the PMOS transistor PT. The PMOS transistor PT may be configured as a pull-up transistor. A precharge voltage corresponding to the back bias voltage VBB2 may be connected to a source terminal of the first NMOS transistor NT1, the wordline WL may be electrically connected to a drain terminal of the first NMOS transistor NT 1, and a wordline enable signal NWEIB may be connected to a gate terminal of the first NMOS transistor NT1. The first NMOS transistor NT1 may be configured as a pull-down transistor. A complementary driving signal PXIB may be connected to a gate terminal of the second NMOS transistor NT2, a precharge voltage corresponding to the back bias voltage VBB2 may be connected to a source terminal of the second NMOS transistor NT2, and the wordline WL may be electrically connected to a drain terminal of the second NMOS transistor NT2. The second NMOS transistor NT2 may be configured as a keeping transistor for maintaining the wordline WL at a ground voltage level when the wordline WL is not selected. The second NMOS transistor NT2 may be connected in parallel to the first NMOS transistor NT1. The sub-wordline driver SWD may drive the wordline WL in response to the wordline enable signal NWEIB and the driving signal PXID. The PMOS transistor PT may pull-up the wordline WL to a level of the driving signal PXID in response to the wordline enable signal NWEIB. The first NMOS transistor NT1 may pull down the wordline WL to a level of the negative voltage VBB2 in response to the wordline enable signal NWEIB. The second NMOS transistor NT2, which may be configured as a keeping transistor, may maintain the wordline WL at a level of the negative voltage VBB2 when the wordline WL is deactivated. To this end, the second NMOS transistor NT2 may switch between a source provided with a negative voltage VBB2 and a drain electrically connected to the wordline WL in response to the driving signal PXIB, which may be complementary to the driving signal PXID. The circuit of the sub-wordline drivers SWD described above is merely an example embodiment, and the circuit of the sub-wordline drivers SWD may be implemented as various circuit components.

Referring to FIG. 2C, each of the sense amplifiers SA may include a plurality of transistors P1_a, P1_b, N1_a, and N1_b. The transistors P1_a, P1_b, N1_a, and N1_b may include a P1_a transistor and a P1_b transistor, which are PMOS transistors, and a N1_a transistor and a N1_b transistor, which are NMOS transistors. The P1_a transistor and the P1_b transistor may be referred to as a PMOS transistor pair, and the N1_a transistor and the N1_b transistor may be referred to as an NMOS transistor pair. A source of the P1_a transistor and a source of the P1_b transistor may be connected to a first control line LA through a first node ND1_a. A source of the N1_a transistor and a source of the N1_b transistor may be connected to a second control line LAB through the second node ND1_b. The first node ND1_a and the second node ND1_b may be referred to as first source node and a second source node, respectively. A drain of the P1_a transistor and a drain of the N1_a transistor may be connected to the first bitline BL1 among the bitlines BL through the first drain node ND1_c. A drain of the P1_b transistor and a drain of the N1_b transistor may be connected to a complementary bitline BL2 among the bitlines BL through the second drain node ND1_d. The sense amplifier SA may sense a voltage change of the first bitline BL1 and amplify the voltage change. When the sense amplifier SA performs sensing and amplification operations, an internal power voltage may be applied to the first node ND1_a through the first control line LA, and the second node ND1_b may be connected to a ground terminal through the second control line LAB. The sense amplifier SA may include a PMOS transistor pair and an NMOS transistor pair, and may be implemented as a circuit component cross-coupled between the transistors, but this is merely an example embodiment, and an example embodiment thereof is not limited thereto. For example, the circuit of the sense amplifier SA may be implemented as various circuit components.

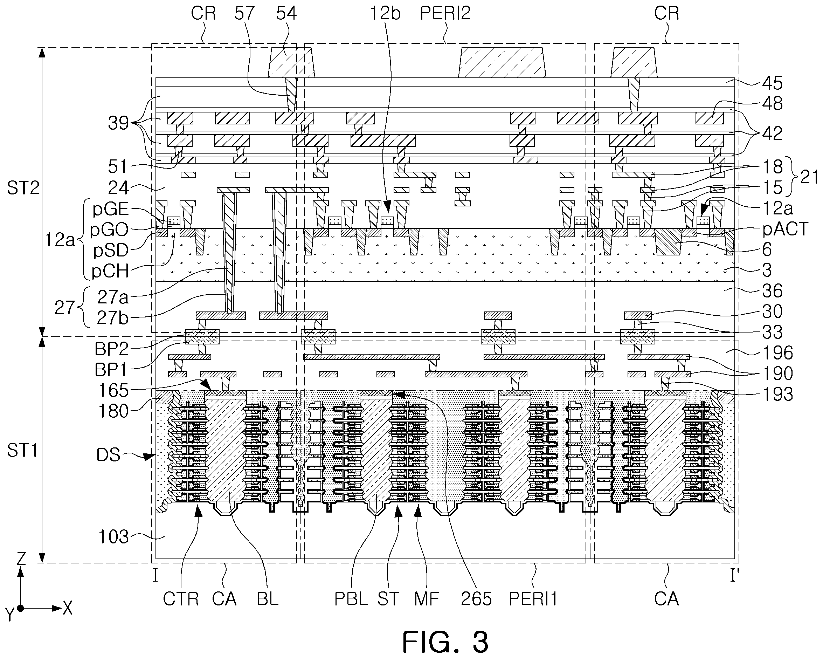

FIG. 3 is a vertical cross-sectional view illustrating the semiconductor device illustrated in FIG. 1, taken along line I-I'.

Referring to FIG. 3, a semiconductor device 1 may include a first structure ST1 and a second structure ST2 vertically overlapping the first structure ST1. The second structure ST2 may be disposed on the first structure ST1.

The first structure ST1 may include memory cell regions CA and a first peripheral circuit region PERI1. The first peripheral circuit region PERI1 may be spaced apart from the memory cell regions CA in the horizontal direction and may be disposed between the memory cell regions CA. As described later, the components of the first peripheral circuit region PERI1 may be disposed at the same level (e.g., at the same layer of semiconductor structure ST1) as the corresponding components of the memory cell regions CA. The term "level" may be used herein to refer to distance or spacing along the Z-direction (also referred to herein as a vertical direction), for example, relative to a reference element or layer, such as the substrate 103. The first peripheral circuit region PERI1 may have a structure the same as or similar to a structure of the memory cell regions CA.

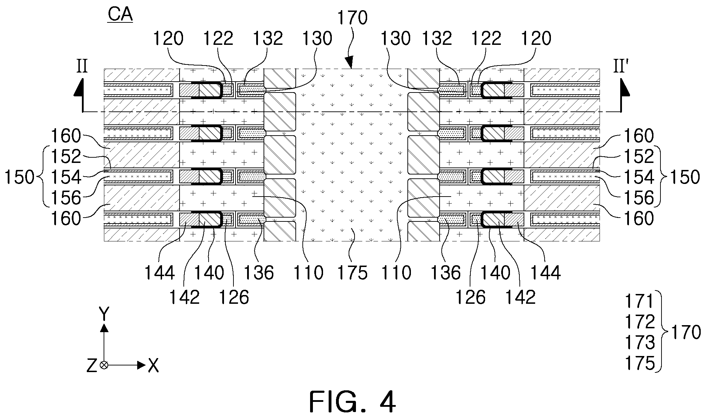

The memory cell region CA may include a cell transistor CTR, a data storage structure DS, and a bitline BL disposed on the substrate 103. The memory cell region CA may further include a contact structure 165 on the bitline BL and a contact plug 180 on the data storage structure DS. The components of the memory cell region CA will be described in greater detail later with reference to FIGS. 4 to 6.

The first peripheral circuit region PERI1 may include a select transistor ST, an antifuse AF, a peripheral bitline PBL disposed on the substrate 103, and a contact structure 265 on the peripheral bitline PBL. At least a portion of the contact structure 265 may be disposed at the same level as a level of the contact structure 165 and the contact plug 180, e.g., relative to the underlying substrate 103. For example, respective surfaces of at least a portion of the contact structure 265, the contact structure 165, and the contact plug 180 may be substantially coplanar. The select transistor ST and the antifuse AF may be disposed at the same level as at least one of the cell transistors CTR.

The first structure ST1 may further include upper interconnections 190, upper vias 193 and an upper insulating layer 196 disposed on the cell transistor CTR, the select transistor ST and the antifuse AF. The contact structure 165, the contact plug 180 and the contact structure 265 may be electrically connected to the corresponding upper interconnections 190 through the upper vias 193, respectively. The upper insulating layer 196 may cover the upper interconnections 190 and the upper vias 193. The term "cover" (or "surround" or "fill") as may be used herein may not require completely covering (or surrounding or filling) the described elements or layers, but may, for example, refer to partially covering (or surrounding or filling) the described elements or layers, for example, with one or more discontinuities therein.

The first structure ST1 may further include a first bonding pad BP1 disposed on an upper surface of the upper insulating layer 196. The memory cell regions CA and the first peripheral circuit region PERI1 may be electrically connected to the second structure ST2 through the first bonding pads BP1.

The second structure ST2 may include core circuit regions CR and a second peripheral circuit PERI2. The second peripheral circuit PERI2 may be spaced apart from the core circuit regions CR in the horizontal direction and may be disposed between the core circuit regions CR. The core circuit regions CR may overlap the memory cell regions CA in the vertical direction, and the second peripheral circuit PERI2 may overlap the first peripheral circuit region PERI1 in the vertical direction.

The second structure ST2 may further include a semiconductor body 3 including peripheral active regions pACT, and a device isolation region 6 defining the peripheral active regions pACT on the semiconductor body 3. The device isolation region 6 may define side surfaces of the peripheral active regions pACT. The device isolation region 6 may be formed of an insulating material.

The semiconductor body 3 may include a semiconductor material, such as a group IV semiconductor, a group III-V compound semiconductor, or a group II-VI compound semiconductor. For example, a group IV semiconductor may include silicon, germanium, or silicon-germanium. The semiconductor body 3 may include single crystal silicon.

The second structure ST2 may further include a core circuit transistor 12a, a peripheral circuit transistor 12b, a peripheral interconnection structure 21 and an insulating structure 24, disposed on the semiconductor body 3.

The core circuit transistor 12a may include peripheral source/drain regions pSD formed in the peripheral active region pACT, a peripheral channel region pCH between the peripheral source/drain regions pSD, and peripheral gates pGO and pGE on the peripheral channel region pCH. The peripheral gate pGO and pGE may include a peripheral gate dielectric layer pGO and a peripheral gate electrode pGE on the peripheral gate dielectric layer pGO. The peripheral circuit transistor 12b may have a structure similar to the core circuit transistor 12a. In an example embodiment, the core circuit transistor 12a and the peripheral circuit transistor 12b may be planar type transistors.

The core circuit transistor 12a may overlap the memory cell region CA in a vertical direction, and the peripheral circuit transistor 12b may overlap the first peripheral circuit region PERI1 in a vertical direction. As illustrated in FIG. 3, according to example embodiments, the first peripheral circuit region PERI1 may be disposed in the first structure ST1 in which the memory cell region CA is disposed, and one or more elements (such as channel structures, bitlines, gate electrodes, and contacts) of the first peripheral circuit region PERI1 may have a structure the same as or similar to a structure of the memory cell regions CA. Accordingly, as compared to a semiconductor device in which the first peripheral circuit region PERI1 is not disposed in the first structure ST1, the area of the peripheral circuit regions PERI1 and PERI2 may be reduced by the area of the first peripheral circuit region PERI1. Accordingly, the size of the semiconductor device 1 may be reduced.

The peripheral interconnection structure 21 may include horizontal interconnections 18 extending in the horizontal direction and vias 15 connected to the horizontal interconnections 18 and extending in the vertical direction. The horizontal interconnections 18 may form a plurality of layers. At least one of the horizontal interconnections 18 may be electrically connected to the peripheral active region pACT through the vias 15.

The insulating structure 24 may cover an upper surface of the semiconductor body 3, and may cover the core circuit transistor 12a, the peripheral circuit transistor 12b and the peripheral interconnection structure 21.

The second structure ST2 may further include a through via structure 27, lower interconnections 30, lower vias 33, a lower insulating layer 36 and a second bonding pad BP2. The through via structure 27 may penetrate the semiconductor body 3 and may extend in the vertical direction. The through via structure 27 may include a through via 27a and an insulating spacer 27b covering a side surface of the through via 27a. The through via 27a may be electrically connected to at least one of the core circuit transistor 12a and the peripheral circuit transistor 12b. The insulating spacer 27b may electrically insulate the through via 27a from the semiconductor body 3.

The lower interconnections 30, the lower vias 33, the lower insulating layer 36 and the second bonding pad BP2 may be disposed below the semiconductor body 3. At least one of the lower interconnections 30 may be electrically connected to the through via 27a. At least one of the lower interconnections 30 may be electrically connected to the second bonding pad BP2 through the lower vias 33.

The lower insulating layer 36 may cover a lower surface of the semiconductor body 3. The lower insulating layer 36 may also cover the lower interconnections 30 and the lower vias 33.

The second structure ST2 may further include interlayer insulating layers 39, barrier insulating layers 42, a passivation layer 45, upper interconnections 48, upper vias 51, upper interconnections 54 and upper vias 57, disposed on the insulating structure 24. The interlayer insulating layers 39 and the barrier insulating layers 42 may be stacked alternately. The passivation layer 45 may be disposed on the uppermost interlayer insulating layers 39.

The upper interconnections 48 may extend in the horizontal direction in the interlayer insulating layers 39, and the upper vias 51 may extend in the vertical direction and may connect the upper interconnections 48 to each other. The upper interconnections 54 may be disposed on the passivation layer 45 and may be electrically connected to the upper interconnections 48 through the upper vias 57 extending in the vertical direction.

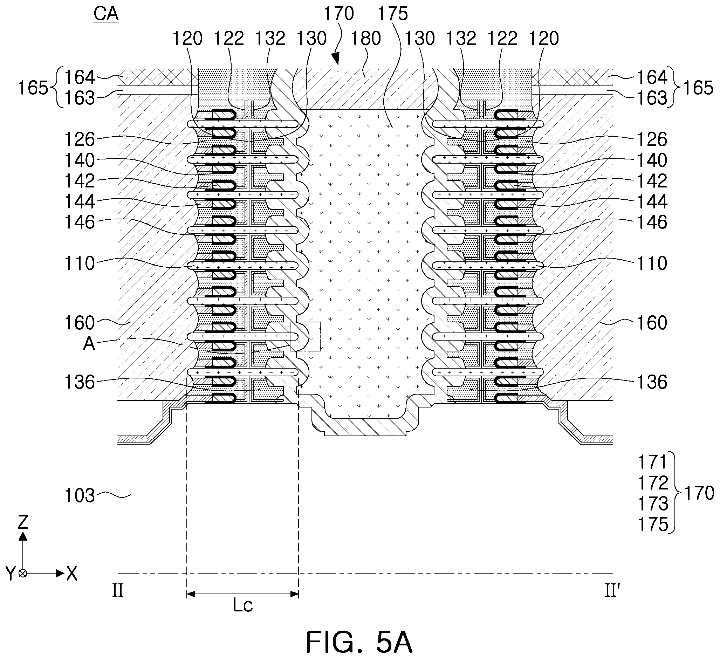

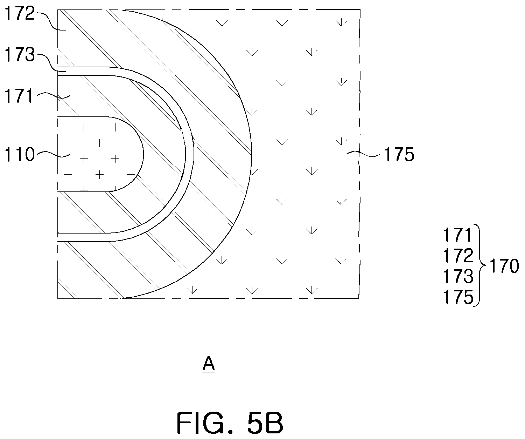

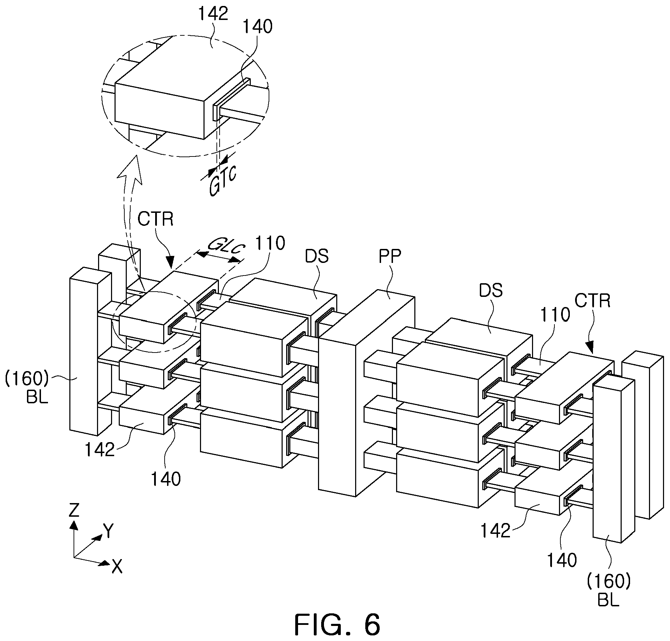

FIG. 4 is a plan view illustrating a memory cell region according to an example embodiment. FIG. 5A is a vertical cross-sectional view illustrating the memory cell region illustrated in FIG. 4, taken along line II-II'. FIG. 5B is an enlarged view illustrating a capacitor structure illustrated in FIG. 5A. FIG. 6 is a perspective view illustrating a memory cell according to an example embodiment.

Referring to FIGS. 4 to 6, a memory cell region CA of the semiconductor device 1 may include a cell channel structure 110, a cell gate electrode 142, a cell bitline 160, and a capacitor structure 170, disposed on a substrate 103.

The cell channel structure 110 may be disposed on the substrate 103 and may extend horizontally in the X-direction. The cell channel structures 110 may be spaced apart from each other in the Y-direction and the vertical (e.g., Z-) direction. In the plan view, the cell channel structure 110 may have a line shape, a bar shape, or a pillar shape extending in the X-direction. In an example, the cell channel structure 110 may include a semiconductor material, such as silicon, germanium, or silicon-germanium.

Each of the cell channel structures 110 may include first and impurity regions and a channel region. The first impurity region and the second impurity region may be disposed on opposing ends in the X-direction of the cell channel structure 110, and the channel region may be disposed between the first impurity region and the second impurity region. The first impurity region may be in contact with the cell bitline 160 and may be electrically connected to the cell bitline 160. The second impurity region may be in contact with the first electrode 171 of the capacitor structure 170 and may be electrically connected to the first electrode 171. The length in the X-direction of the first impurity region and the length in the X-direction of the second impurity region may be different from each other, or may be the same. The channel region may overlap cell gate electrodes 142 in the vertical direction. When the cell channel structure 110 is formed of a semiconductor material, each of the first impurity region and the second impurity region may include impurities, and the impurities may have N-type or P-type conductivity.

A portion of the cell channel structure 110 and the cell gate electrode 142 overlapping the cell gate electrode 142 in the vertical direction may be included in the cell transistor CTR in FIG. 2A. At least a portion of the first impurity region may correspond to the first source/drain region of the cell transistor CTR in FIG. 2A, and at least a portion of the second impurity region may correspond to the second source/drain region of the cell transistor CTR in FIG. 2A. At least a portion of the channel region may correspond to a channel of the cell transistor CTR in FIG. 2A. The first impurity region may provide a region for directly connecting the cell transistor CTR to the bitline BL, and the second impurity region may provide a region for directly connecting the cell transistor CTR to the data storage structure DS.

In another example, the cell channel structures 110 may include at least one of oxide semiconductors, such as hafnium-silicon oxide (HSO), hafnium-zinc oxide (HZO), indium-zinc oxide (IZO), indium-gallium oxide (IGO), indium-tin oxide (ITO), indium-gallium-zinc oxide (IGZO), and indium-tin-zinc oxide (ITZO).

In another example, the cell channel structures 110 may include a two-dimensional (2D material) of which atoms may form a specific crystal structure and may form a channel of a transistor. The two-dimensional material layer may include at least one of a transition metal dichalcogenide material layer (TMD material layer), a black phosphorous material layer, and a hexagonal boron-nitride material layer (hBN material layer). For example, the two-dimensional material layer may include at least one of BiOSe, Crl, WSe2, MoS2, TaS, WS, SnSe, ReS, β-SnTe, MnO, AsS, P(black), InSe, h-BN, GaSe, GaN, SrTiO, MXene, and Janus 2D materials, which may form two-dimensional materials.

The cell gate electrodes 142 may be disposed on the substrate 103 and may extend horizontally in the Y-direction. The cell gate electrodes 142 may be spaced apart from each other in the X-direction and in the vertical direction. The cell gate electrodes 142 may overlap the channel regions of the cell channel structure 110 in the vertical direction. The cell gate electrodes 142 may extend in the Y-direction and may have a line shape, a bar shape, or a pillar shape in the plan view.

The cell gate electrodes 142 may include a conductive material, and the conductive material may include a doped semiconductor material (e.g., doped silicon, doped germanium, or the like), conductive metal nitride (e.g., titanium nitride, tantalum nitride, tungsten nitride, or the like), metal (e.g., tungsten, titanium, tantalum, cobalt, aluminum, ruthenium, or the like), and metal-semiconductor compound (e.g., tungsten silicide, cobalt silicide, titanium silicide, or the like). At least one of the cell gate electrodes 142 may correspond to the wordlines WL described with reference to FIG. 2A. In an example embodiment, the cell gate electrode 142 may be disposed in a gate all around structure surrounding the cell channel structure 110.

In some example embodiments, the cell gate electrodes 142 may be disposed on an upper surface and a lower surface of each cell channel structure 110, and two cell gate electrodes 142 adjacent to each cell channel structure 110 may be configured as a wordline WL. In some example embodiments, the memory cell transistor MCT may have a single gate structure. For example, one of the cell gate electrodes 142 may be disposed adjacent to each cell channel structure 110, and a cell gate electrode 142 may be configured as a wordline WL.

The memory cell region CA of the semiconductor device 1 may further include a cell gate dielectric layer 140, a gate capping layer 144, and an insulating layer 146. The cell gate dielectric layer 140 may be disposed in a gate all around structure surrounding the cell channel structure 110 and may cover an upper surface, a lower surface and a side surface of the cell gate electrode 142. The gate capping layer 144 may be disposed between the cell gate electrode 142 and the cell bitline 160. A portion of the cell gate dielectric layer 140 may be disposed between the cell channel structure 110 and the gate capping layer 144. The gate capping layer 144 may be spaced apart from the cell bitline 160, and the insulating layer 146 may be disposed between the gate capping layer 144 and the cell bitline 160. The insulating layer 146 may be in contact with the cell bitline 160.

The cell gate dielectric layer 140 may include at least one of silicon oxide, silicon nitride, a low-κ material, and a high-κ material. The high-κ material may indicate a dielectric material having a dielectric constant higher than that of silicon oxide, and the low-κ material may indicate a dielectric material having a dielectric constant lower than that of silicon oxide. The high-κ material may be, for example, metal oxide or metal oxynitride. The high-κ material may be, for example, at least one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}), and praseodymium oxide (Pr₂O₃). The cell gate dielectric layer 140 may be formed as a single layer or multiple layers formed of the above-described materials.

The gate capping layers 144 may include at least one of an insulating material, for example, silicon nitride, silicon oxynitride, and silicon oxycarbide.

The memory cell region CA of the semiconductor device 1 may further include a first buffer layer 120, a first liner 122, and a first gap-fill insulating layer 126, disposed between the cell channel structures 110. The first buffer layer 120, the first liner 122 and the first gap-fill insulating layer 126 may be in contact with the cell gate dielectric layer 140. For example, the first buffer layers 120 may extend in the horizontal direction on an upper surface and a lower surface of the cell channel structures 110, and may extend in the vertical direction between the cell channel structures 110. The first liner 122 may be disposed conformally on the first buffer layer 120. The first gap-fill insulating layer 126 may fill a space between the cell gate dielectric layers 140 adjacent to each other. The first gap-fill insulating layer 126 may be in contact with the gate capping layer 144 and the cell bitline 160. The first buffer layer 120 and the first gap-fill insulating layer 126 may include silicon oxide, and the first liner 122 may include silicon nitride.

The cell bitlines 160 may extend in the X-direction and the vertical direction on the substrate 103. The cell bitlines 160 may be spaced apart from each other in the X-direction and the Y-direction. A plurality of cell channel structures 110 stacked in a vertical direction may be electrically connected to the cell bitline 160. For example, the cell bitline 160 may be electrically connected to the first impurity regions of the cell channel structures 110. The cell bitlines 160 may include at least one of doped semiconductor material, conductive metal nitride, metal, and metal-semiconductor compound. For example, the cell bitlines 160 may include doped polysilicon. The cell bitlines 160 may correspond to the bitline BL described with reference to FIG. 2A.

The memory cell region CA of the semiconductor device 1 may further include a contact structure 165 disposed on the cell bitline 160. The contact structure 165 may include a first conductive layer 163 and a second conductive layer 164. The first conductive layer 163 may be in contact with an upper surface of the cell bitline 160, and the second conductive layer 164 may be disposed on the first conductive layer 163.

The first conductive layer 163 may include a metal-semiconductor compound. For example, the metal-semiconductor compound may be configured as a layer siliciding a portion of cell bitline 160. For example, the metal-semiconductor compound may include cobalt silicide (CoSi), titanium silicide (TiSi), nickel silicide (NiSi), tungsten silicide (WSi), or other metal silicides, or may include nitride such as TiSiN. The second conductive layer 164 may include a metal material such as titanium (Ti), tantalum (Ta), tungsten (W), and aluminum (Al).

The memory cell region CA of the semiconductor device 1 may further include insulating structures 150. In the plan view, the insulating structures 150 may extend in the X-direction and may be spaced apart from each other in the Y-direction. The insulating structures 150 may be disposed alternately with the cell bitlines 160 in the Y-direction. The insulating structures 150 may spatially isolate and electrically insulate the cell bitlines 160 from each other.

Each of the insulating structures 150 may include the first insulating pattern 152, the second insulating pattern 154, and the third insulating pattern 156. The first insulating pattern 152 may be in contact with the cell channel structure 110, the gate capping layer 144 and the cell bitline 160. The second insulating pattern 154 may be formed conformally along an internal wall of the first insulating pattern 152. The third insulating pattern 156 may fill an internal space of the second insulating pattern 154.

The capacitor structure 170 may be in contact with the cell channel structures 110 and may be electrically connected to the cell channel structure 110. The capacitor structure 170 may include first electrodes 171, a second electrode 172 on the first electrodes 171, a plate electrode 175 on the second electrode 172, and a capacitor dielectric 173 between the first electrodes 171 and the second electrode 172. The first electrodes 171 may be in contact with the second impurity region of each cell channel structure 110. Each of the first electrodes 171 may have a cylindrical shape, but an example embodiment thereof is not limited thereto, and in example embodiments, the first electrode 171 may have a pillar shape.

Nodes of the first electrodes 171 may be separated from each other between the cell channel structures 110. For example, the first electrodes 171 may be spaced apart from each other. The first electrodes 171 may be referred to as "storage node electrodes." The first electrodes 171 may include at least one of a doped semiconductor material, conductive metal nitride, metal, and a metal-semiconductor compound.

The second electrode 172 may cover the first electrodes 171, may extend in a vertical direction, and may cover an upper surface of the substrate 103. The capacitor dielectric 173 may extend between the first electrodes 171 and the second electrode 172. The capacitor dielectric 173 may cover an upper surface of the substrate 103 and may electrically insulate the substrate 103 from the capacitor structure 170. In an example embodiment, the substrate 103 may include an impurity region disposed on an upper surface of the substrate 103 and in contact with the second electrode 172. The capacitor structure 170 may not be electrically connected to the substrate 103 by the impurity region. Portions of the second electrode 172 and the capacitor dielectric 173, and the first electrode 171 may correspond to the data storage structure DS illustrated in FIG. 2A. The plate electrode 175 may correspond to the plate electrode PP.

The second electrode 172 may include at least one of a doped semiconductor material, conductive metal nitride, metal, and a metal-semiconductor compound. In an example embodiment, the first electrode 171 and the second electrode 172 may include titanium nitride. For example, the capacitor dielectric 173 may include at least one of high-κ materials such as zirconium oxide (ZrO₂), aluminum oxide (Al₂O₃), and hafnium oxide (Hf₂O₃).

The plate electrode 175 may cover the second electrode 172 and may extend in the vertical direction. The plate electrode 175 may include at least one of doped semiconductor material, conductive metal nitride, metal, and a metal-semiconductor compound. In an example embodiment, the plate electrode 175 may include silicon-germanium.

The contact plug 180 may be disposed on the plate electrode 175. The contact plug 180 may be electrically connected to the data storage structures DS through the plate electrode 175. The contact plug 180 may include at least one of a doped semiconductor material, conductive metal nitride, metal, and a metal-semiconductor compound.

The memory cell region CA of the semiconductor device 1 may further include a second buffer layer 130, a second liner 132, and a second gap-fill insulating layer 136 disposed between the cell channel structures 110. The second buffer layer 130, the second liner 132 and the second gap-fill insulating layer 136 may be in contact with the first electrode 171 of the capacitor structure 170. For example, the second buffer layers 130 may extend in a horizontal direction on an upper surface and a lower surface of the cell channel structures 110, and may extend in a vertical direction between the cell channel structures 110. The second liner 132 may be disposed conformally on the second buffer layer 130. The second gap-fill insulating layer 136 may be disposed on the second liner 132 and may fill a space between the cell channel structures 110 adjacent thereto. The second buffer layer 130 and the second gap-fill insulating layer 136 may include silicon oxide, and the second liner 132 may include silicon nitride.

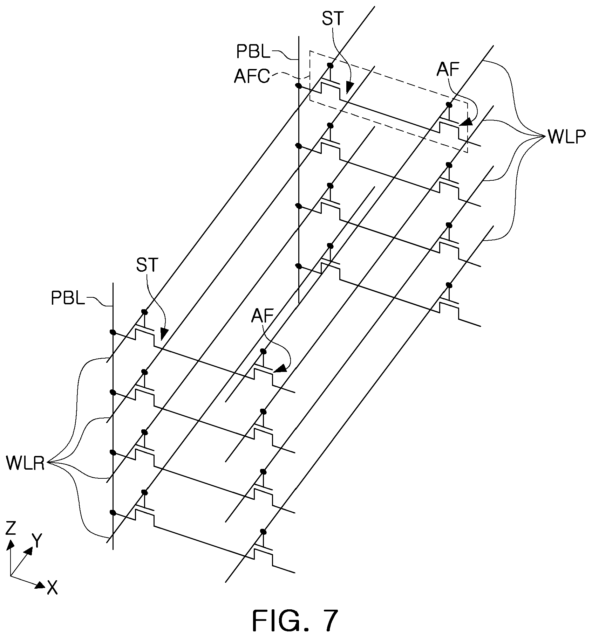

FIG. 7 is a circuit diagram illustrating a peripheral circuit device in a first peripheral circuit region according to an example embodiment.

Referring to FIG. 7, in an example embodiment, the first peripheral circuit region PERI1 may include an antifuse array. The antifuse array may include antifuse memory cells AFC arranged along peripheral bitlines PBL, programming wordlines WLP and read wordlines WLR. Each of the antifuse memory cells AFC may include a select transistor ST and an antifuse AF connected to each other in series.

The select transistor ST may be connected between the bitlines BL and the antifuse AF and may be controlled by the read wordlines WLR. The read wordlines WLR may be connected to select gates of the select transistors ST.

A source region of the antifuse AF may be connected to a drain region of the select transistor ST, and a drain region of the antifuse AF may be electrically floating. The antifuse AF may be programmed by causing insulation breakdown of the antifuse gate dielectric layer by applying a high voltage to the antifuse gate dielectric layer. The antifuse AF may be programmed according to a voltage applied to the programming wordlines WLP. The programming wordlines WLP may be connected to the antifuse gates of the antifuses AF.

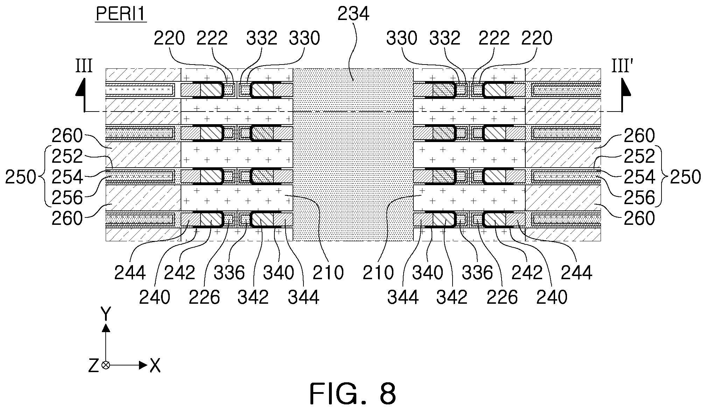

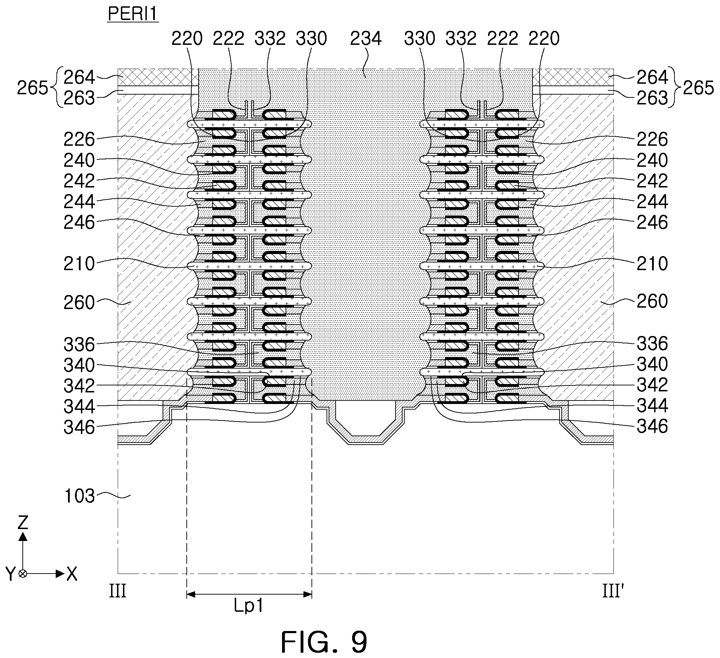

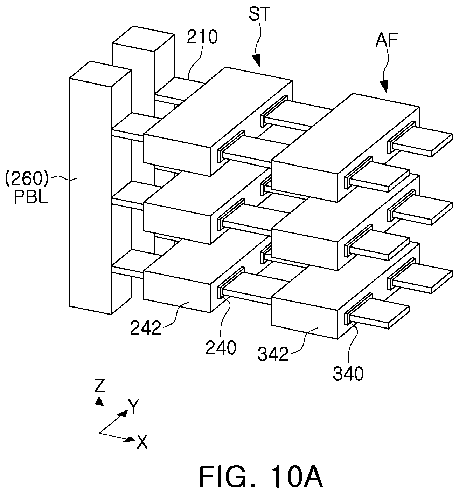

FIG. 8 is a plan view illustrating a first peripheral circuit region according to an example embodiment. FIG. 9 is a vertical cross-sectional view illustrating a first peripheral circuit region illustrated in FIG. 8, taken along line III-III'. FIG. 10A is a perspective view illustrating an antifuse memory cell in a first peripheral circuit region according to an example embodiment.

Referring to FIGS. 8 to 10A, the first peripheral circuit region PERI1 may include a peripheral channel structure 210, a first peripheral gate electrode 242, a second peripheral gate electrode 342 and a peripheral bitline 260, disposed on the substrate 103.

The peripheral channel structure 210 may be disposed on the substrate 103 and may extend horizontally in the X-direction. The peripheral channel structures 210 may be spaced apart from each other in the Y-direction and the vertical direction. The peripheral channel structures 210 may have a structure the same as or similar to a structure of the cell channel structures 110 illustrated in FIGS. 4 and 5. The peripheral channel structure 210 may be disposed at the same level as at least one of the cell channel structures 110, e.g., relative to the underlying substrate 103.

The first peripheral gate electrodes 242 may be disposed on the substrate 103 and may extend horizontally in the Y-direction. The first peripheral gate electrodes 242 may be spaced apart from each other in the X-direction and the vertical direction. The first peripheral gate electrodes 242 may overlap the channel regions of the peripheral channel structure 210 in the vertical direction.

The second peripheral gate electrodes 342 may be disposed on the substrate 103 and may extend horizontally in the Y-direction. The second peripheral gate electrodes 342 may be spaced apart from each other in the X-direction and the vertical direction. In an example embodiment, the first peripheral gate electrode 242 and the second peripheral gate electrode 342 may be disposed in a gate all around structure surrounding the peripheral channel structure 210. For example, portions of each peripheral channel structure 210 may be surrounded by the first peripheral gate electrode 242 and the second peripheral gate electrode 342, and the first peripheral gate electrode 242 may be disposed closer to the peripheral bitline 260 than the second peripheral gate electrode 342.

At least one of the first peripheral gate electrodes 242 may correspond to the read wordline WLR described with reference to FIG. 7. At least one of the second peripheral gate electrodes 342 may correspond to the programming wordline WLP described with reference to FIG. 7. A portion of the peripheral channel structure 210 vertically overlapping the first peripheral gate electrode 242 may correspond to a channel region, and the channel region and the first peripheral gate electrode 242 may form the select transistor ST described with reference to FIG. 7. A portion of the peripheral channel structure 210 vertically overlapping the second peripheral gate electrode 342 may correspond to a channel region, and the channel region and the second peripheral gate electrode 342 may be included in the antifuse AF described with reference to FIG. 7. The first peripheral gate electrode 242 and the second peripheral gate electrode 342 may be disposed at the same level as at least one of the cell gate electrodes 142, e.g., relative to the underlying substrate 103.

The first peripheral circuit region PERI1 may further include a first buffer layer 220, a first liner 222 and a first gap-fill insulating layer 226 disposed between the peripheral channel structures 210. The first buffer layer 220, the first liner 222 and the first gap-fill insulating layer 226 may have structures the same as or similar to the structures of the first buffer layer 120, the first liner 122 and the first gap-fill insulating layer 126 described with reference to FIGS. 4 and 5, respectively.

The first peripheral circuit region PERI1 may further include a first peripheral gate dielectric layer 240, a first peripheral gate capping layer 244, and a first peripheral insulating layer 246. The first peripheral gate dielectric layer 240, the first peripheral gate capping layer 244 and the first peripheral insulating layer 246 may have structures the same as or similar to the structures of the cell gate dielectric layer 140, the gate capping layer 144 and the insulating layer 146 described with reference to FIGS. 4 and 5, respectively. For example, the first peripheral gate dielectric layer 240 may be disposed in a gate all around structure surrounding the peripheral channel structure 210 and may cover an upper surface, a lower surface a and side surface of the first peripheral gate electrode 242. The first peripheral gate capping layer 244 may be disposed between the first peripheral gate electrode 242 and the peripheral bitline 260. The first peripheral gate capping layer 244 may be spaced apart from the peripheral bitline 260, and the first peripheral insulating layer 246 in contact with the peripheral bitline 260 may be disposed between the first peripheral gate capping layer 244 and the peripheral bitline 260.

The peripheral bitlines 260 may extend in the X-direction and the vertical direction on the substrate 103. The peripheral bitlines 260 may be spaced apart from each other in the X-direction and the Y-direction. A plurality of peripheral channel structures 210 stacked in a vertical direction may be electrically connected to the peripheral bitline 260. The peripheral bitlines 260 may correspond to the peripheral bitlines PBL described with reference to FIG. 7.

The first peripheral circuit region PERI1 may further include a contact structure 265 disposed on the peripheral bitline 260. The contact structure 265 may include a first conductive layer 263 and a second conductive layer 264. The contact structure 265 may also be referred to as "peripheral contact structure." As illustrated in FIG. 3, at least a portion of the contact structure 265 may be disposed at the same level as the contact structure 165 and the contact plug 180, e.g., relative to the underlying substrate 103.

The first peripheral circuit region PERI1 may further include insulating structures 250. In the plan view, insulating structures 250 may extend in the X-direction and may be spaced apart from each other in the Y-direction. The insulating structures 250 may be disposed alternately with peripheral bitlines 260 in the Y-direction. The insulating structures 250 may spatially isolate and electrically insulate the peripheral bitlines 260 from each other.

Each of the insulating structures 250 may include a first insulating pattern 252, a second insulating pattern 254 and a third insulating pattern 256. The first insulating pattern 252 may be in contact with the peripheral channel structure 210, the first peripheral gate capping layer 244 and the peripheral bitline 260. The second insulating pattern 254 may be formed conformally along an internal wall of the first insulating pattern 252. The third insulating pattern 256 may fill an internal space of the second insulating pattern 254.

The first peripheral circuit region PERI1 may further include a second buffer layer 330, a second liner 332 and a second gap-fill insulating layer 336 disposed between the peripheral channel structures 210. The second buffer layer 320, the second liner 322 and the second gap-fill insulating layer 336 may have structures the same as or similar to the structures of the first buffer layer 220, the first liner 222 and the first gap-fill insulating layer 226, respectively.

The first peripheral circuit region PERI1 may further include a second peripheral gate dielectric layer 340, a second peripheral gate capping layer 344, and a second peripheral insulating layer 346. The second peripheral gate dielectric layer 340, the second peripheral gate capping layer 344 and the second peripheral insulating layer 346 may have a structure the same as or similar to the structures of the first peripheral gate dielectric layer 240, the first peripheral gate capping layer 244 and the first peripheral insulating layer 246, respectively. For example, the second peripheral gate dielectric layer 340 may be disposed as a gate all around structure surrounding the peripheral channel structure 210 and may cover an upper surface, a lower surface and a side surface of the second peripheral gate electrode 342. The second peripheral gate capping layer 344 may cover the side surface of the second peripheral gate electrode 342 not covered by the second peripheral gate dielectric layer 340. The second peripheral insulating layer 346 may be disposed between the peripheral channel structure 210 and the second peripheral gate capping layer 344, and may be in contact with the second peripheral gate dielectric layer 340.

The first peripheral circuit region PERI1 may further include an interlayer insulating layer 234. The interlayer insulating layer 234 may be disposed between the peripheral bitlines 260 and may extend in the Y-direction. The interlayer insulating layer 234 may extend in the vertical direction and may be in contact with the peripheral channel structures 210, the second gap-fill insulating layers 336 and the second peripheral gate capping layers 344. Also, an upper portion of the interlayer insulating layer 234 may extend in the horizontal direction and may be in contact with the first liners 222, the first peripheral gate dielectric layers 240, the first peripheral gate capping layers 244, the peripheral bitlines 260, the contact structures 265 and the second liners 332.

A first end of the peripheral channel structure 210 of the first peripheral circuit region PERI1 may be in contact with the peripheral bitline 260 and may be electrically connected to the peripheral bitline 260. A second end of the peripheral channel structure 210 may be opposite to the first end and may be in contact with the interlayer insulating layer 234. The second end of the peripheral channel structure 210 may be electrically floating, and when a high voltage is applied to the second peripheral gate electrode 342, insulation breakdown may occur in the second peripheral gate dielectric layer 340 and the antifuse AF may be programmed.

In an example embodiment, the first peripheral gate electrode 242 and the peripheral bitline 260 of the first peripheral circuit region PERI1 may be formed in the same process of forming the cell gate electrode 142 and the cell bitline 160 of the memory cell region CA, respectively. Therefore, the process of manufacturing the semiconductor device may be simplified. The second peripheral gate electrode 342 may be formed in a process different from the process of forming the cell gate electrode 142 and the first peripheral gate electrode 242. For example, the process of forming a gate electrode on the peripheral channel structure 210 may be performed twice, and the first and second peripheral gate electrodes 242 and 342 may be formed by performing the processes of forming a gate electrode twice.

In an example embodiment, a length Lc in the X-direction of the cell channel structure 110 illustrated in FIG. 5A may be different from the length Lp1 in the X-direction of the peripheral channel structure 210 illustrated in FIG. 9. For example, the length Lp1 in the X-direction of the peripheral channel structure 210 may be greater than the length Lc in the X-direction of the cell channel structure 110.

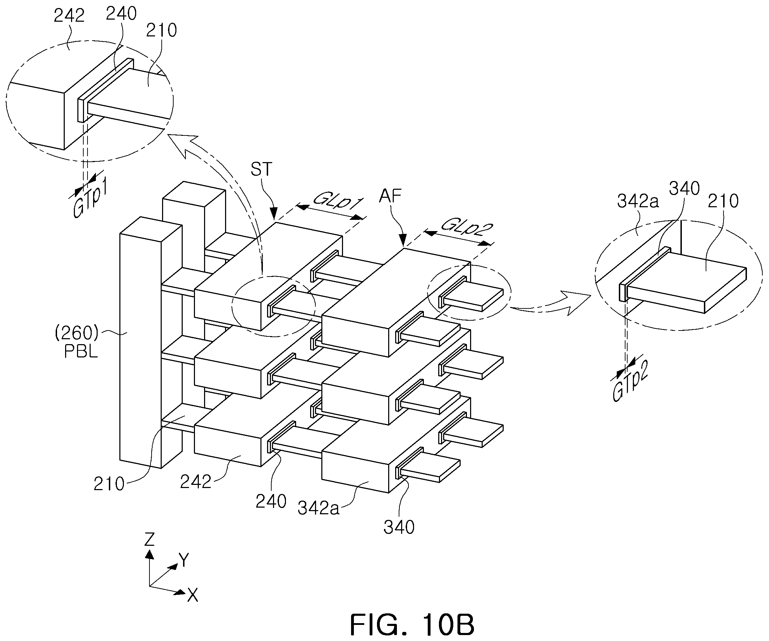

FIG. 10B is a perspective view illustrating an antifuse memory cell in a first peripheral circuit region according to an example embodiment.

Referring to FIG. 10B, the antifuse memory cell may include a select transistor ST including a first peripheral gate electrode 242 and an antifuse AF including a second peripheral gate electrode 342a. In an example embodiment, the threshold voltage of select transistor ST may be different from the threshold voltage of the antifuse AF. As in the context of a transistor, the threshold voltage of an antifuse may refer to the minimum voltage required for conduction in the antifuse. For example, at least one of a gate length of the select transistor ST, the type and the number of materials used in the gate electrode, the type and the number of materials used in the gate dielectric layer, and the thickness of the gate dielectric layer may be different from those of the antifuse AF.

In an example embodiment, a gate length GLp1 of the first peripheral gate electrode 242 may be different from a gate length GLp2 of the second peripheral gate electrode 342a. Here, "gate length" may indicate the length by which the gate electrodes 242 and 342a cover the peripheral channel structure 210, for example, along a direction between source/drain regions at opposing ends of the channel structure 210. In other words, the gate length GLp1 may indicate the length in the X-direction of the first peripheral gate electrode 242, and the gate length GLp2 may indicate the length in the X-direction of the second peripheral gate electrode 342a. In an example embodiment, the gate length GLp1 of the first peripheral gate electrode 242 may be the same as the gate length GLc of the cell gate electrode 142 illustrated in FIG. 6.

In an example embodiment, the thickness GTp1 of the first peripheral gate dielectric layer 240, which may be the gate dielectric layer of the select transistor ST, may be different from the thickness GTp2 of the second peripheral gate dielectric layer 340, which may be the gate dielectric layer of the antifuse AF. For example, the thickness GTp2 of the second peripheral gate dielectric layer 340 may be smaller than the thickness GTp1 of the first peripheral gate dielectric layer 240. Accordingly, the insulating breakdown voltage of the second peripheral gate dielectric layer 340 of the antifuse AF may be lowered or reduced. In an example embodiment, the thickness GTp1 of the first peripheral gate dielectric layer 240 may be the same as the thickness GTc of the cell gate dielectric layer 140 illustrated in FIG. 6.

In an example embodiment, the second peripheral gate electrode 342a may include a material different from the first peripheral gate electrode 242. The first peripheral gate electrode 242 may include the same material as that of the cell gate electrode 142.

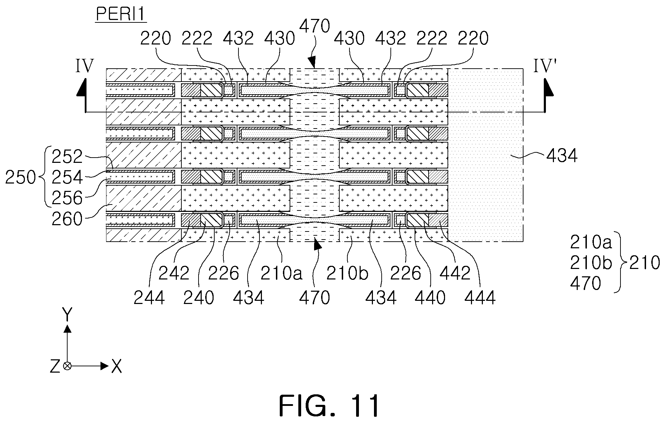

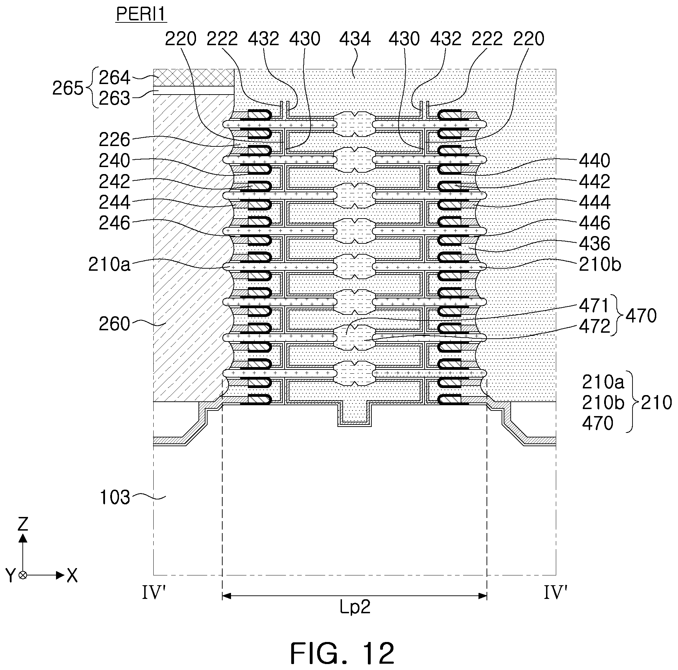

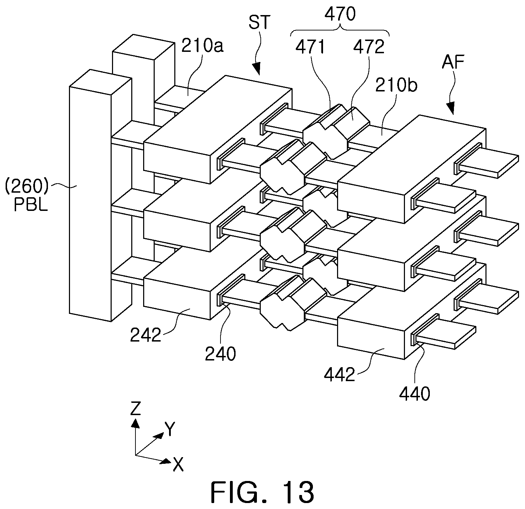

FIG. 11 is a plan view illustrating a first peripheral circuit region according to an example embodiment. FIG. 12 is a vertical cross-sectional view illustrating a first peripheral circuit region illustrated in FIG. 11, taken along line IV-IV'. FIG. 13 is a perspective view illustrating an antifuse memory cell in a first peripheral circuit region according to an example embodiment.

Referring to FIGS. 11 to 13, a first peripheral circuit region PERI1 may include a first buffer layer 220, a first liner 222, a first gap-fill insulating layer 226, a first peripheral gate dielectric layer 240, a first peripheral gate capping layer 244, a first peripheral insulating layer 246, an insulating structure 250, a peripheral bitline 260 and a contact structure 265, and the components may have structures the same as or similar to the structures of the components described with reference to FIGS. 8 and 9.

The first peripheral circuit region PERI1 may include a peripheral channel structure 210, a first peripheral gate electrode 242 and a second peripheral gate electrode 442. The peripheral channel structure 210 may include a first peripheral channel structure 210a, a second peripheral channel structure 210b, and an epitaxial layer 470 connecting the first peripheral channel structure 210a to the second peripheral channel structure 210b.

The first peripheral gate electrode 242 and the second peripheral gate electrode 442 may have structures the same as or similar to the structures of the first peripheral gate electrode 242 and the second peripheral gate electrode 342 described with reference to FIGS. 8 and 9, respectively. In an example embodiment, the first peripheral gate electrode 242 may vertically overlap the first peripheral channel structure 210a, and the second peripheral gate electrode 442 may vertically overlap the second peripheral channel structure 210b. A portion of the first peripheral channel structure 210a vertically overlapping the first peripheral gate electrode 242 may correspond to a channel region, and the channel region and the first peripheral gate electrode 242 may form the select transistor ST described with reference to FIG. 7. A portion of the second peripheral channel structure 210b vertically overlapping the second peripheral gate electrode 442 may correspond to a channel region, and the channel region and the second peripheral gate electrode 442 may be included in the antifuse AF described with reference to FIG. 7.

The first peripheral circuit region PERI1 may further include a second buffer layer 430, a second liner 432 and a second gap-fill insulating layer 436 disposed between the second peripheral channel structures 210b. The second buffer layer 430, the second liner 432 and the second gap-fill insulating layer 436 may have structures the same as or similar to the structures of the first buffer layer 220, the first liner 222 and the first gap-fill insulating layer 226, respectively.

The first peripheral circuit region PERI1 may further include a second peripheral gate dielectric layer 440, a second peripheral gate capping layer 444 and a second peripheral insulating layer 446. The second peripheral gate dielectric layer 440, the second peripheral gate capping layer 444 and the second peripheral insulating layer 446 may have structures the same as or similar to the structures of the first peripheral gate dielectric layer 240, the first peripheral gate capping layer 244 and the first peripheral insulating layer 246, respectively.

The epitaxial layer 470 may be disposed between the first peripheral channel structure 210a and the second peripheral channel structure 210b, which are spaced apart from each other in the X-direction. The epitaxial layer 470 may include a first epitaxial layer 471 and a second epitaxial layer 472. The first epitaxial layer 471 and the second epitaxial layer 472 may be formed by a selective epitaxial growth (SEG) method from the first peripheral channel structure 210a and the second peripheral channel structure 210b, respectively. For example, the first epitaxial layer 471 and the second epitaxial layer 472 may grow from ends of the first peripheral channel structure 210a and the second peripheral channel structure 210b, respectively, and may be integrated with and coupled to each other. The first epitaxial layer 471 may extend in the X-direction from the end of the first peripheral channel structure 210a toward the second peripheral channel structure 210b, and the second epitaxial layer 472 may extend in the X-direction toward the first peripheral channel structure 210a. Maximum vertical thicknesses of the first epitaxial layer 471 and the second epitaxial layer 472 may be greater than maximum vertical thicknesses of the first peripheral channel structure 210a and the second peripheral channel structure 210b, respectively. In an example embodiment, the first epitaxial layer 471 and the second epitaxial layer 472 may include impurities. The first epitaxial layer 471 and the second epitaxial layer 472 may electrically connect the first peripheral channel structure 210a to the second peripheral channel structure 210b.

The first peripheral circuit region PERI1 may further include an interlayer insulating layer 434. The interlayer insulating layer 434 may extend in the Y-direction. The interlayer insulating layer 234 may extend in the vertical direction and may be in contact with the second liners 432, the second gap-fill insulating layers 436, the second peripheral gate capping layers 444, the first epitaxial layers 471 and the second epitaxial layers 472. Also, an upper portion of the interlayer insulating layer 434 may extend in the horizontal direction and may be in contact with the first liners 222, the first peripheral gate dielectric layers 240, the first peripheral gate capping layers 244, the peripheral bitlines 260 and the contact structure 265.

A first end of the peripheral channel structure 210 of the first peripheral circuit region PERI1 may be in contact with the peripheral bitline 260 and may be electrically connected to the peripheral bitline 260. A second end of the peripheral channel structure 210 may be opposite to the first end and may be in contact with the interlayer insulating layer 434. The second end of the peripheral channel structure 210 may be electrically floating.

In an example embodiment, the first peripheral gate electrode 242, the second peripheral gate electrode 442 and the peripheral bitline 260 of the first peripheral circuit region PERI1 may be formed in the same process of forming the cell gate electrode 142 and the cell bitline 160 of the memory cell region CA. Differently in the memory cell region CA, an epitaxial process to form the first epitaxial layers 471 and the second epitaxial layers 472 may be further performed in the first peripheral circuit region PERI1.

In an example embodiment, the length Lc in the X-direction of the cell channel structure 110 illustrated in FIG. 5A may be different from the length Lp2 in the X-direction of the peripheral channel structure 210 illustrated in FIG. 12. For example, the length Lp2 in the X-direction of the peripheral channel structure 210 may be greater than the length Lc in the X-direction of the cell channel structure 110.

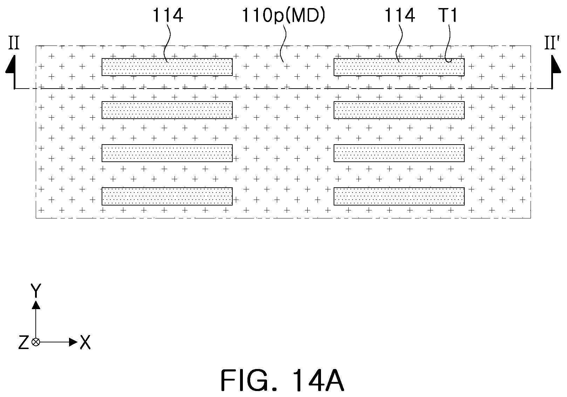

FIGS. 14A to 18B are plan views and vertical cross-sectional views illustrating processes of a method of manufacturing a semiconductor device in order according to an example embodiment. Specifically, FIGS. 14A, 15A, 16A, 17A and 18A are plan views corresponding to FIG. 4, and FIGS. 14B, 15B, 16B, 17B and 18B are vertical cross-sectional views taken along line II-II' in FIGS. 14A, 15A, 16A, 17A and 18A, respectively.

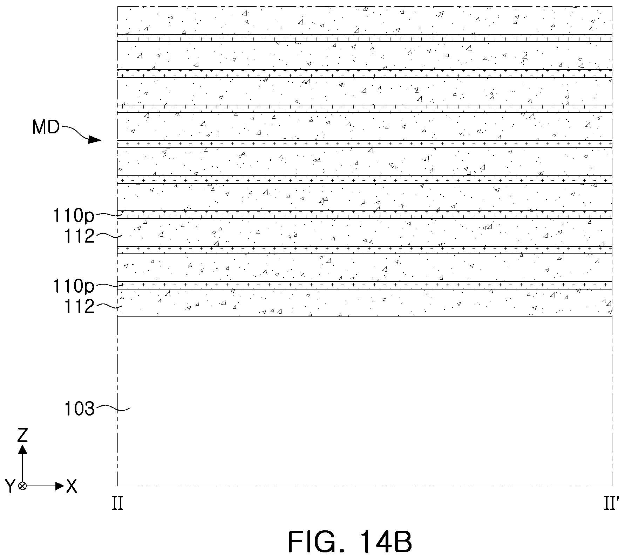

Referring to FIGS. 14A and 14B, a mold structure MD may be formed on the substrate 103. The mold structure MD may include channel material layers 110p and sacrificial layers 112 stacked alternately. An upper surface of the substrate 103 may be in contact with one of the sacrificial layers 112. The sacrificial layers 112 may include a material having an etch selectivity of the channel material layers 110p.

In an example embodiment, the channel material layers 110p may include silicon and the sacrificial layers 112 may include silicon-germanium, silicon oxide, silicon nitride, silicon carbide, silicon oxynitride, or combinations thereof. In an example embodiment, the channel material layers 110p may include silicon oxide, and the sacrificial layers 112 may include silicon nitride, silicon oxynitride, or a combination thereof.

Insulating patterns 114 may be disposed in the mold structure MD. The insulating patterns 114 may be formed by forming first trenches T1 extending in the X-direction by anisotropically etching the mold structure MD, and filling the first trenches T1 with an insulating material. The insulating patterns 114 may extend in the X-direction and may be spaced apart from each other in the X-direction and the Y-direction. The insulating patterns 114 may include at least one of silicon oxide, silicon nitride and silicon oxynitride. For example, the insulating patterns 114 may include silicon oxide. In FIG. 14A, six insulating patterns 114 are illustrated, but an example embodiment thereof is not limited thereto, and the number of the insulating patterns 114 and the arrangement thereof may vary in example embodiments.

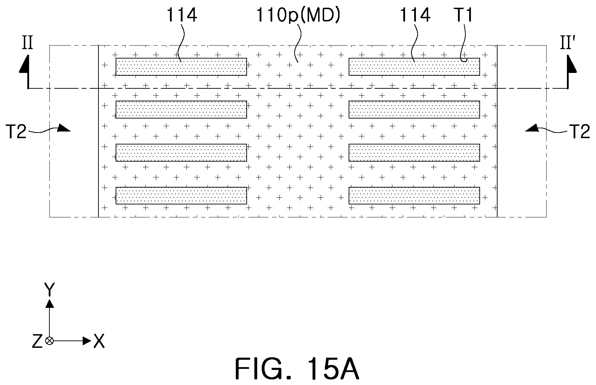

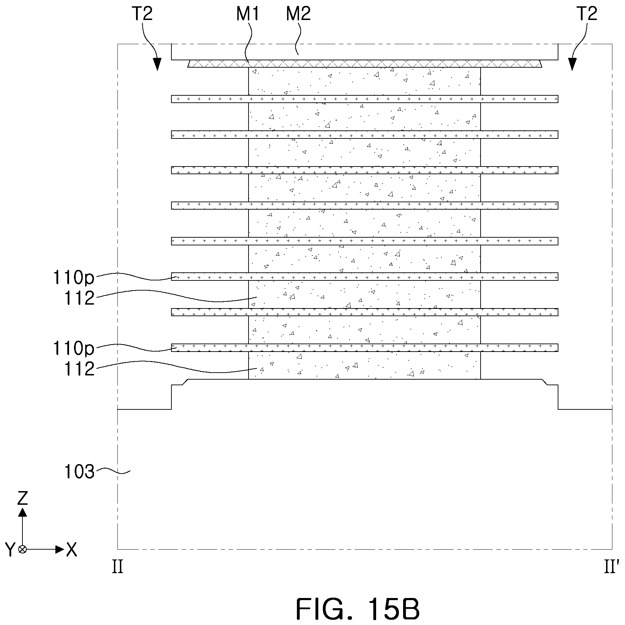

Referring to FIGS. 15A and 15B, second trenches T2 may be formed. The second trenches T2 may be formed by anisotropically etching the mold structure MD using the first mask layer M1 and the second mask layer M2 as etch masks. The second trenches T2 may be disposed adjacent to the insulating patterns 114 and may extend in the Y-direction. In the etching process, the upper surface of the substrate 103 may be partially etched.

Thereafter, the sacrificial layers 112 may be partially etched. For example, the sacrificial layers 112 may be partially etched in the horizontal direction by supplying etchant into the second trenches T2. The channel material layers 110p having etch selectivity with the sacrificial layers 112 may not be etched. By etching the sacrificial layers 112, upper and lower surfaces of a portion of the channel material layers 110p may be exposed by the second trenches T2. The term "exposed" may be used to describe relationships between elements and/or certain intermediate processes in fabricating a completed semiconductor device, but may not necessarily require exposure of the particular region, layer, structure or other element in the context of the completed device.

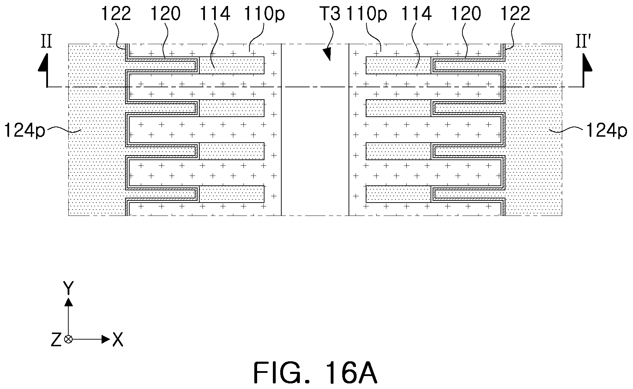

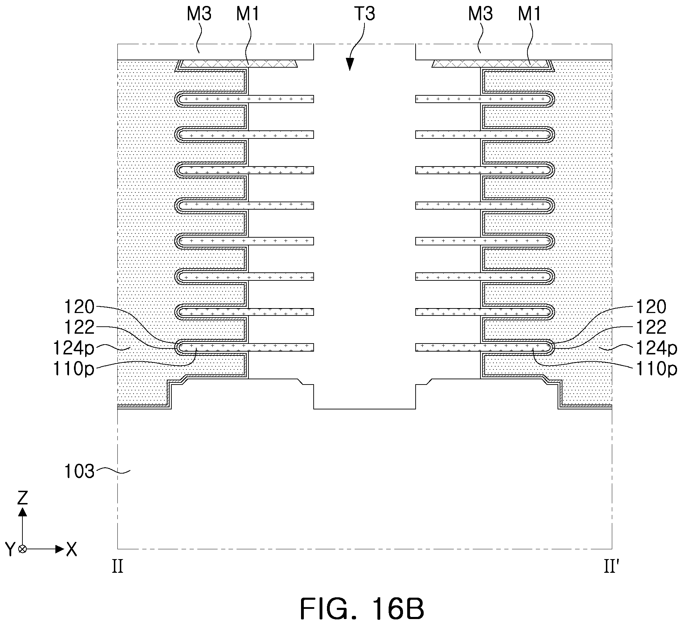

Referring to FIGS. 16A and 16B, the channel material layers 110p exposed by the second trenches T2 may be partially etched. For example, portions of the channel material layers 110p exposed by the second trenches T2 may be etched and may be spaced apart from each other in the Y-direction. Through the etching process, the insulating patterns 114 may be exposed by the second trenches T2.

Thereafter, the insulating patterns 114 may be partially etched. For example, through the etching process, the second trenches T2 may extend in the X-direction and the length in the X-direction of the insulating patterns 114 may be reduced. A portion of side surfaces of the channel material layers 110p may be exposed by the second trenches T2.

The first buffer layer 120, the first liner 122 and the first gap-fill insulating layer 124p may be formed in the second trenches T2. In the plan view, the first buffer layer 120 may extend conformally along the channel material layers 110p and may be in contact with the insulating patterns 114. In the cross-sectional view, the first buffer layer 120 may cover an upper surface of the substrate 103 and upper and lower surfaces of the channel material layers 110p. The first liner 122 may be disposed on the first buffer layer 120 and may be conformally formed along the first buffer layer 120. The first gap-fill insulating layer 124p may be formed on the first liner 122 and may fill the second trench T2.

The first buffer layer 120, the first liner 122 and the first gap-fill insulating layer 124p may include at least one of silicon oxide, silicon nitride and silicon oxynitride. The first liner 122 may include a material having etch selectivity with the first buffer layer 120 and the first gap-fill insulating layer 124p. For example, the first liner 122 may include silicon nitride, and the first buffer layer 120 and the first gap-fill insulating layer 124p may include silicon oxide.

Third trenches T3 may be formed. The third trenches T3 may be formed by anisotropically etching the mold structure MD using the first mask layer M1 and a third mask layer M3 as etching masks. The third trenches T3 may extend in the Y-direction and may be disposed alternately with the second trenches T2 in the X-direction. In the etching process, an upper surface of the substrate 103 may be partially etched.

Thereafter, the sacrificial layers 112 may be partially etched. For example, the sacrificial layers 112 may be partially etched by supplying an etchant in the third trenches T3. A portion of upper and lower surfaces of the channel material layers 110p may be exposed by the third trenches T3.

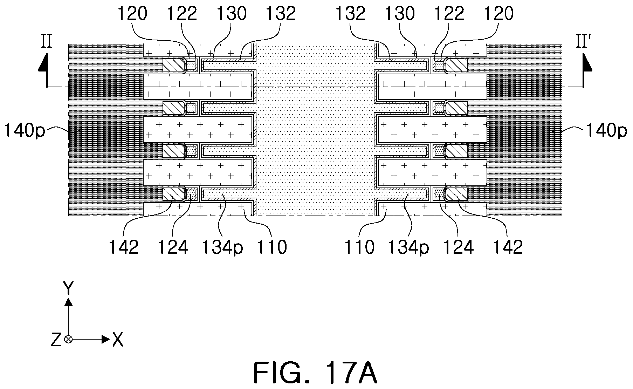

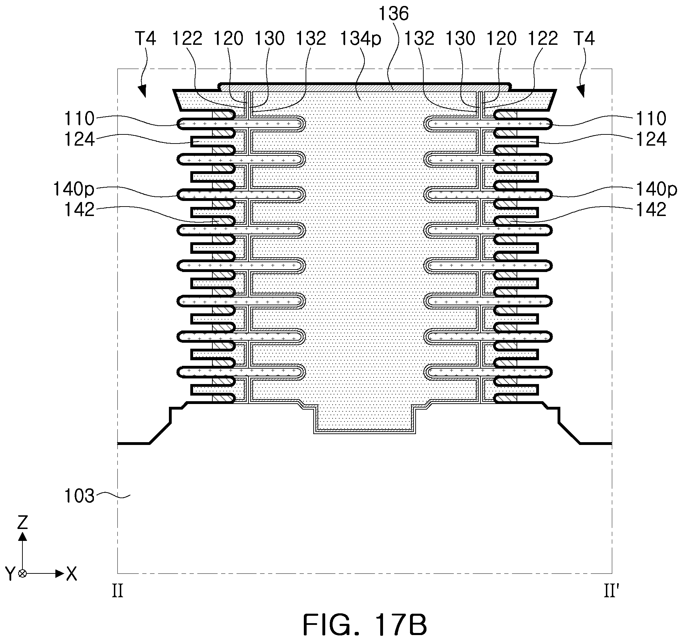

Referring to FIGS. 17A and 17B, the channel material layers 110p exposed by the third trench T may be partially etched. For example, portions of the channel material layers 110p exposed by the third trench T2 may be etched and cell channel structures 110 spaced apart from each other in the Y-direction may be formed. Through the etching process, the insulating patterns 114 may be exposed by the third trench T3.

Thereafter, the insulating patterns 114 may be removed, and a portion of the side surfaces of the cell channel structures 110 may be exposed by the third trench T3.

A second buffer layer 130, a second liner 132, a second gap-fill insulating layer 134p and an upper insulating layer 136 may be formed in the third trenches T3. In the plan view, the second buffer layer 130 may extend conformally along the cell channel structures 110 and may be in contact with the first buffer layer 120. In the cross-sectional view, the second buffer layer 130 may cover an upper surface of the substrate 103 and an upper surface and a lower surface of the cell channel structures 110. The second liner 132 may be disposed on the second buffer layer 130 and may be conformally formed along the second buffer layer 130. The second gap-fill insulating layer 134p may be formed on the second liner 132 and may fill the third trench T3. The upper insulating layer 136 may cover an upper surface of the second gap-fill insulating layer 134p.

The second buffer layer 130, the second liner 132 and the second gap-fill insulating layer 134p may include at least one of silicon oxide, silicon nitride and silicon oxynitride. The second liner 132 may include a material having etch selectivity with the second buffer layer 130 and the second gap-fill insulating layer 134p. For example, the second liner 132 may include silicon nitride, and the second buffer layer 130 and the second gap-fill insulating layer 134p may include silicon oxide. The upper insulating layer 136 may include silicon nitride.

The first buffer layer 120, the first liner 122 and the first gap-fill insulating layer 124p may be partially etched, and the dielectric material layer 140p and the cell gate electrode 142 may be formed. For example, fourth trenches T4 may be formed by partially etching the first buffer layer 120, the first liner 122 and the first gap-fill insulating layer 124p. The fourth trenches T4 may be formed in a space in which the second trenches T2 have been disposed. The first gap-fill insulating layer 124p may be etched such that the first gap-fill insulating layer 124 may be formed.

First, by partially etching the first buffer layer 120, the first liner 122 and the first gap-fill insulating layer 124p, upper and lower surfaces of the cell channel structures 110 may be exposed by the fourth trenches T4. The dielectric material layer 140p may be formed conformally along internal walls of the fourth trenches T4. For example, the substrate 103 and the dielectric material layer 140p may be disposed conformally along the cell channel structures 110 and the first gap-fill insulating layers 124. Thereafter, the cell gate electrodes 142 may be formed by forming a conductive material on the dielectric material layer 140p and etching back the conductive material. The cell gate electrodes 142 may be disposed between the cell channel structures 110 and the first gap-fill insulating layers 124.

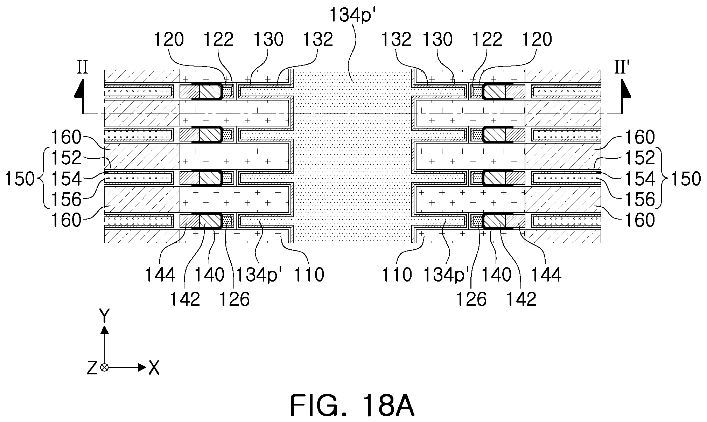

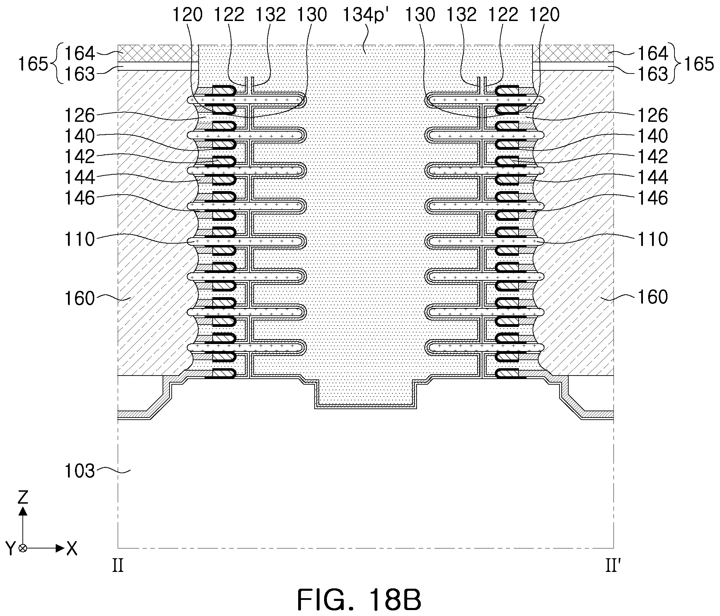

Referring to FIGS. 18A and 18B, the insulating structures 150 and the cell bitlines 160 may be formed in the fourth trenches T4. For example, the dielectric material layer 140p may be partially etched and the cell channel structures 110 may be exposed by the fourth trenches T4. The dielectric material layer 140p may be etched to form the cell gate dielectric layer 140. A conductive material may be formed to be in contact with the cell channel structures 110, and cell bitlines 160 may be formed by patterning the conductive material.

Before forming the conductive material, a gate capping layer 144 covering the side surface of the cell gate electrode 142 may be formed. The first gap-fill insulating layer 126 and the insulating layer 146 may be formed by depositing an insulating material between the exposed cell channel structures 110. The first gap-fill insulating layer 126 may be disposed in a position corresponding to the first gap-fill insulating layer 124, and may fill a gap between the gate capping layers 144 adjacent to each other. The insulating layer 146 may be disposed between the cell gate dielectric layer 140 and the cell bitline 160.

The cell bitline 160 may be in contact with the cell channel structures 110, the first gap-fill insulating layers 126, the gate capping layers 144 and the insulating layers 146. The cell bitline 160 may have a scallop shape in the cross-sectional view, but an example embodiment thereof is not limited thereto.

In the plan view, the insulating structures 150 may be disposed between the cell bitlines 160. For example, the insulating structures 150 and the cell bitlines 160 may extend in the X-direction, and the insulating structures 150 may be disposed alternately with the cell bitlines 160 in the Y-direction. The insulating structures 150 may spatially isolate and electrically insulate the cell bitlines 160 from each other.

Each of the insulating structures 150 may include a first insulating pattern 152, a second insulating pattern 154 and a third insulating pattern 156. The first insulating pattern 152 may be in contact with the cell channel structure 110, the gate capping layer 144 and the cell bitline 160. The second insulating pattern 154 may be formed conformally along an internal wall of the first insulating pattern 152. The third insulating pattern 156 may fill an internal space of the second insulating pattern 154.

The contact structure 165 may be formed on the cell bitline 160. The contact structure 165 may include a first conductive layer 163 and a second conductive layer 164. The first conductive layer 163 may be in contact with an upper surface of the cell bitline 160, and the second conductive layer 164 may be disposed on the first conductive layer 163. The contact structure 165 may also be referred to as "cell contact structure."

Before the contact structure 165 is formed, the upper insulating layer 136 may be removed and the second gap-fill insulating layer 134p may be exposed, and after the contact structure 165 is formed, by depositing an insulating material on the second gap-fill insulating layer 134p, the second gap-fill insulating layer 134p' may be formed. The second gap-fill insulating layer 134p' may cover a side surface of the contact structure 165.

Referring again to FIGS. 4 and 5, a capacitor structure 170 and a contact plug 180 may be formed. The capacitor structure 170 may be electrically connected to each cell channel structure 110 and may be disposed between the cell bitlines 160. The capacitor structure 170 may be in contact with the cell channel structures 110 and may extend in a vertical direction. The capacitor structure 170 may include first electrodes 171 in contact with the cell channel structures 110, a second electrode 172 on the first electrodes 171, a plate electrode 175 on the second electrode 172, and a capacitor dielectric 173 between the first electrodes 171 and the second electrode 172. The contact plug 180 may be disposed on the plate electrode 175.

According to the aforementioned example embodiments, since the first peripheral circuit region is disposed at the same level or layer of the semiconductor structure as the memory cell region, the size of the semiconductor device may be reduced. Spatially relative terms such as 'upper,' 'upper surface,' 'below,' 'lower,' 'lower surface,' 'side surface,' and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features.

## Claims

1. A semiconductor device (1), comprising:
a memory cell region (CA); and
a first peripheral circuit region (PERI1) adjacent the memory cell region (CA) in a first horizontal direction (X),
wherein the memory cell region (CA) comprises:
cell channel structures (110) extending in the first horizontal direction (X) and stacked and spaced apart from each other in a vertical direction (Z) that is perpendicular to the first horizontal direction (X);
a cell bitline (160) extending in the vertical direction (Z) and in contact with the cell channel structures (110); and
cell gate electrodes (142) overlapping the cell channel structures (110) in the vertical direction (Z) and extending in a second horizontal direction (Y) intersecting the first horizontal direction (X),
wherein the first peripheral circuit region (PERI1) comprises:
a peripheral channel structure (210) extending in the first horizontal direction (X);
a peripheral bitline (260) extending in the vertical direction (Z) and in contact with the peripheral channel structure (210); and
a first peripheral gate electrode (242) and a second peripheral gate electrode (342) overlapping the peripheral channel structure (210) in the vertical direction (Z) and extending in the second horizontal direction (Y),
wherein the first peripheral gate electrode (242) is closer to the peripheral bitline (260) than the second peripheral gate electrode (342), and
wherein at least one of the cell channel structures (110) is at a same level as the peripheral channel structure (210) in the vertical direction (Z).

2. The semiconductor device (1) of claim 1, wherein at least one of the cell gate electrodes (142) is at a same level as at least one of the first peripheral gate electrode (242) and the second peripheral gate electrode (342) in the vertical direction (Z).

3. The semiconductor device (1) of claim 1 or 2, wherein the first peripheral gate electrode (242) is at a same level as the second peripheral gate electrode (342) in the vertical direction (Z).

4. The semiconductor device (1) of any one of claims 1 to 3, wherein the peripheral channel structure (210) comprises a first end that is electrically connected to the peripheral bitline (260), and a second end that is opposite the first end and is electrically floating.

5. The semiconductor device (1) of any one of claims 1 to 4, further comprising:
an interlayer insulating layer (234, 434) in contact with the peripheral channel structure (210),
wherein a first end of the peripheral channel structure (210) is in contact with the peripheral bitline (260), and a second end of the peripheral channel structure (210) is opposite the first end and is in contact with the interlayer insulating layer (234, 434).

6. The semiconductor device (1) of any one of claims 1 to 5,
wherein the peripheral channel structure (210) comprises a first portion and a second portion overlapping the first peripheral gate electrode (242) and the second peripheral gate electrode (342), respectively, in the vertical direction (Z),
wherein the first peripheral gate electrode (242) and the first portion of the peripheral channel structure (210) provide a select transistor (ST), and
wherein the second peripheral gate electrode (342) and the second portion of the peripheral channel structure (210) provide an antifuse.

7. The semiconductor device (1) of claim 6, wherein the select transistor (ST) has a first threshold voltage and the antifuse has a second threshold voltage that is different from the first threshold voltage.

8. The semiconductor device (1) of claim 6 or 7, wherein a gate length (GLp1) of the first peripheral gate electrode (242) is different from a gate length (GLp2) of the second peripheral gate electrode (342) in the first horizontal direction (X).

9. The semiconductor device (1) of any one of claims 6 to 8, further comprising:
a first peripheral gate dielectric layer (240) between the peripheral channel structure (210) and the first peripheral gate electrode (242) and a second peripheral gate dielectric layer (340) between the peripheral channel structure (210) and the second peripheral gate electrode (342),
wherein the second peripheral gate dielectric layer (340) is thinner than the first peripheral gate dielectric layer (240).

10. The semiconductor device (1) of any one of claims 6 to 9, wherein the peripheral channel structure (210) comprises a first peripheral channel structure (210a), a second peripheral channel structure (210b) that is spaced apart from the first peripheral channel structure (210a) in the first horizontal direction (X), and an epitaxial layer (470) connecting the first peripheral channel structure (210a) to the second peripheral channel structure (210b).

11. The semiconductor device (1) of claim 10, wherein the epitaxial layer (470) comprises a first epitaxial layer (471) extending from an end of the first peripheral channel structure (210a) toward the second peripheral channel structure (210b), and a second epitaxial layer (472) extending from an end of the second peripheral channel structure (210b) toward the first peripheral channel structure (210a).

12. The semiconductor device (1) of claim 11, wherein a maximum vertical thickness of the first epitaxial layer (471) is greater than a maximum vertical thickness of at least one of the first peripheral channel structure (210a) or the second peripheral channel structure (210b), in the vertical direction (Z).

13. The semiconductor device (1) of any one of claims 1 to 12, wherein the peripheral channel structure (210) is longer than the cell channel structures (110) in the first horizontal direction (X).

14. The semiconductor device (1) of any one of claims 1 to 13, wherein a gate length (GLp1) of the first peripheral gate electrode (242) is the same as a gate length (GLc) of at least one of the cell gate electrodes (142) in the first horizontal direction (X).

15. The semiconductor device (1) of any one of claims 1 to 14, further comprising:
a second peripheral circuit region (PERI2) overlapped with the first peripheral circuit region (PERI1) in the vertical direction (Z), and
a core circuit region overlapped with the memory cell region (CA) in the vertical direction (Z).
